# EUROPEAN PATENT APPLICATION

(11) **EP 0 848 585 A1**
(43) Date of publication of application: **17.06.1998**
(21) Application number: 97309548.2
(22) Date of filing: 26.11.1997
(51) Int. Cl.: H05K 1/16, H01C 17/18

(54) **Process for the manufacture of printed circuit boards with plated resistors**

(30) Priority: 13.12.1996 US 768031
(71) Applicant: MACDERMID INCORPORATED, Waterbury, Connecticut 06702 (US); Hadco Corporation, Salem, New Hampshire 03079 (US)
(72) Inventor: Larson, Gary B., Cheshire, Connecticut (US); Bengston, Jon, West Hartford, Connecticut 06107 (US); Schweikher, William, Wolcott, Connecticut (US); Kologe, Donna, Thomaston, Connecticut (US); DeRego, Todd, Nashua, New Hampshire (US); Raaberg, Bruce, S., Mont Vernon, New Hampshire (US); Sorenson, Bruce, Londonderry, New Hampshire (US)
(74) Representative: Jenkins, Peter David

(57) **Abstract**

A process is revealed whereby resistors can be manufactured integral with the printed circuit board. The resistors (16) are formed by plating resistive material onto the insulative substrate (10) between conductive areas (13,14) using a plating mask (15).

## Description

The present invention relates to a process for the manufacture of double-sided or multilayer printed circuit boards with printed plated resistors. The method proposed produces printed circuits with integral resistors which are printed and plated in place on the surfaces of the printed circuit board. The process produces printed circuit boards with resistors in a manner that is more efficient and economical than previously possible.

In the manufacture of printed circuits, it is now commonplace to provide planar boards having circuitry on each side thereof(eg. double sided circuit boards). It is also commonplace to produce boards comprised of integral planar laminates of insulating substrate and conductive metal, wherein one or more parallel innerlayers or planes of the conductive metal, separated by insulating substrate, are present within the structure with the exposed outer surfaces, along with the inner planes, of the laminate containing printed circuit patterns (eg. multilayer circuit boards).

In double sided and multilayer circuit boards, it is necessary to provide interconnection between or among the various layers and/or sides of the board containing the conductive circuitry. This is achieved by providing metalized, conductive thru-holes in the board communicating with the sides and layers requiring electrical interconnection. The predominantly employed method for providing conductive thru-holes is by electroless deposition of metal on the non-conductive surfaces of the thru-holes which have been drilled or punched through the board. Typically the electroless deposition is followed by electrolytic deposition of metal in the holes to build conductive metal to the required thickness. Recently some processes have allowed for direct electroplating in the thru-holes without need for prior electroless deposition.

The typical manufacturing sequence for producing printed circuit boards begins with a copper-clad laminate. The copper clad laminate comprises a glass reinforced epoxy insulating substrate with copper foil adhered to both planar surfaces of said substrate, although other types of insulating substrates such as paper phenolic and polyimide, have been used. First the thru-holes are drilled or punched in the copper clad laminate thereby exposing the hole surfaces of insulating substrate material. The holes are then subjected to a chemical plating process which deposits conductive metal in the holes as well as on the copper surfaces. A plating mask is provided on the outer surfaces in the negative image of the circuitry desired. Subsequently copper is electroplated on all surfaces, not covered by the plating mask, to a predetermined thickness, followed by a thin deposition of tin to act as an etch resist. The plating resist is then stripped and the exposed copper surfaces (ie., those not plated with the etch resist) are etched away. Finally the etch resist is removed and printed circuit board is finished with one of a number of known finishing methods such as solder mask, followed by hot air solder leveling. The foregoing process is typically called the pattern plate process and is suitable for producing double sided printed circuit boards or multilayer boards. However in the case of multilayer boards, the starting material is a copper clad laminate which comprises inner planes of circuitry called innerlayers.

Simple printed circuit boards and the innerlayers of a multilayer circuit board are produced through a technique called print and etch. In this manner a photopolymer is laminated or dried on the copper surfaces of a copper clad laminate. The photopolymer is then selectively imaged using a negative and developed to produce a positive image of the desired circuit pattern on the surfaces of the copper clad laminate. The exposed copper is then etched away and the photopolymer stripped, revealing the desired circuit pattern. As an alternative the photopolymer may be directly screened onto the copper clad laminate in an imagewise fashion, followed by the foregoing etching and stripping.

The semi-additive process may be used in conjunction with the print and etch process to produce double sided or multilayer print and etch boards with plated thru-holes. In this process a copper clad laminate or a multilayer package with copper foil on the exterior surfaces is processed through the print and etch process as given above. Holes are then drilled in the board In a desired array. A plating resist is then applied to cover substantially the entire outer surfaces of the board except for the holes and the circuits. The exposed areas are then plated electrolessly.

In addition to the foregoing, many other processes have been utilized to produce printed circuit boards. Some of these processes are detailed in U.S. Patent Nos. 3,982,045; 5,246,816 and 4,847,114, the teachings each of which are incorporated herein by reference in their entirety. However, in the prior art processes, the circuits are made such that resistors, if required, need to be provided externally from the circuit board itself. (eg. mounted on the surface of the circuit board as an appendage).

The inventors herein have discovered a process whereby resistors can be printed and plated as an integral part of the circuitry of the printed circuit board. This provides for an efficient and economical way of providing the necessary resistors. In addition the process provides for further minaturization of the printed circuit boards produced in comparison to those produced by prior art methods. Typical processes in this regard are described U.S. Patent Nos. 3,808,576 and 2,662,957, the teachings both of which are incorporated by reference herein in their entirety.

Embodiments of the present invention will now be described, by way of example only, with reference to the accompanying drawings, in which:-

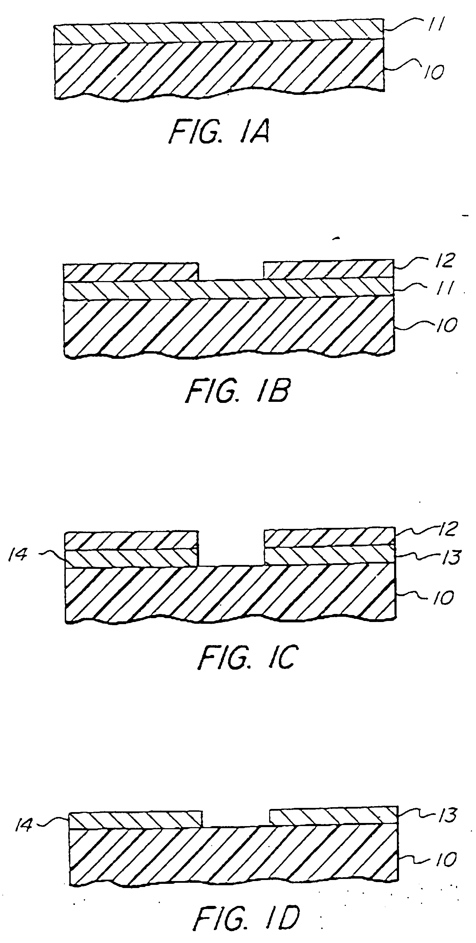

Figure 1A represents one side of the copper clad laminate (although both sides would most likely be processed in the same way) with insulating dielectric substrate, 10, and the attached copper foil, 11.

Figure 1B indicates the presence of an imaged resist, 12, on the copper foil, 11. The resist, 12, has already been imaged and developed and therefore covers only the desired portions of the copper foil, 11.

Figure 1C indicates that the exposed copper has now been etched away leaving unconnected resist covered copper traces, 13 and 14 on the substrate, 10.

Figure 1D indicates that the resist has now been completely stripped away leaving only the desired copper traces, 13 and 14 on the substrate, 10.

Figure 1E shows the application of a plating resist, 15, which covers the entire area of the board except the portions where the resistor will be plated.

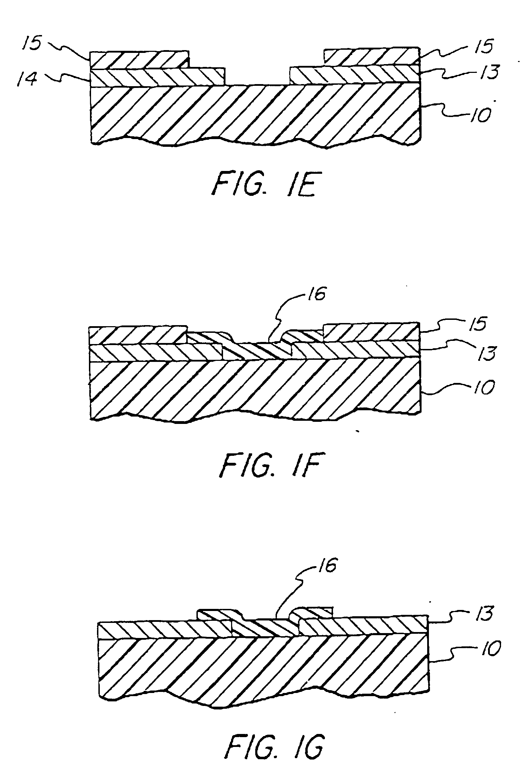

Figure 1F shows the plated resistor, 16, connecting the previously unconnected copper traces, 13 and 14.

Figure 1G shows the circuit after the plating resist has been stripped away.

The current invention proposes a process for printing and plating resistors as an integral part of a printed circuit board. The foregoing process is described in its basic form by the following sequence of processing steps:
a). Apply an etch resist on the surface of a metal clad laminate (or multilayer package) in a desired pattern. The desired pattern should preferably define the conductive circuits desired in a positive manner and should define the areas between the circuits and locations for the resistors in a negative manner;
b). Etch away the exposed copper and preferably remove the etch resist;
c). Activate the surfaces to accept plating thereon;
d). Apply a plating mask which covers substantially all of the surfaces except for the areas where the resistors are to be plated;
e). Plate the exposed areas with a resistive material; and
f). Strip away the plating mask.
As an equivalent to the foregoing process, foregoing steps a and b can be replaced by an additive process with the following steps:
a.1.). Activate the surfaces of a bare dielectric substrate to accept plating thereon;
a.2.). Apply a plating mask to the dielectric substrate such that the desired circuits are defined in a negative manner and the areas between the circuits and the locations for the resistors are defined in a positive manner;
a.3.) Plate the desired circuitry;
a.4.) Strip away the plating resist; and

Subsequently follow steps (c) through (f) noted previously.

The processes described herein provide a method of forming a resistor or between two conductive areas, which areas are upon and separated by an insulating substrate. The method described provides for plating a resistive material onto the insulating substrate, which is between the conductive areas, such that the resistive material connects the conductive areas. The processes described are particularly useful in producing printed circuit boards with plated resistors which are integral with the circuits. The most basic processing sequence is described as follows:
a). apply an etch resist onto the surfaces of a metal clad laminate such that the resist defines the desired circuitry in a positive manner and the areas between the circuits including the locations for the resistors are defined in a negative manner;
b). etch away exposed copper surfaces and strip the resist;
c). activate the surfaces to accept plating thereon;
d). apply a plating mask such that the plating resist covers all or substantially all of the surfaces except for the areas where the resistors are to be plated (ie. such that the resistor areas are defined in a negative manner;
e). plate the exposed areas;
f). strip away the plating mask;

Steps (a) and (b) together call for the creation of defined circuitry on the surfaces of a metal clad dielectric laminate (or multilayer package - several layers of circuitry containing one or more innerlayers of circuitry which have been laminated into a single planar package. The innerlayers may or may not contain the plated resistors of this invention. If so then the innerlayers may be fabricated by the process described herein). The metal clad laminate may optionally have thru holes in it in a desired array. The thru holes may or may not be plated at this point. The key here is the definition and creation of circuit pattern on the surfaces of the metal clad laminate along with the definition and creation of specific breaks in the circuitry where the resistors will be plated (the "resistor areas"). The length and width of the specific resistor areas will obviously directly impact the resistance achieved after plating.

The definition and creation of circuitry and the resistor areas can be accomplished in many ways. The most prevalent way is through the subtractive process as described in current steps (a) and (b). In the subtractive process, a metal (usually copper) clad laminate is used. The metal clad laminate comprises a planar dielectric substrate with metal foil adhered to both exterior surfaces. As discussed, the dielectric substrate is typically glass reinforced epoxy, but can also be a variety of other insulative materials known in the art. In any case a resist pattern is applied to the metal surfaces such that the resist defines the circuits in a positive manner and the areas between the circuits and the resistor areas in a negative manner. The most typical way of accomplishing this is to use a photoresist. In this case the photoresist is applied to the metal surfaces in either liquid or dry form. The photoresist is then selectively exposed to actinic radiation through a negative. The unexposed areas of the resist are developed away revealing the desired pattern. As an alternative the resist may be screened onto the metal surfaces directly in the desired pattern. After the circuits are defined with the resist, the exposed copper areas are etched away and the resist is stripped revealing the circuits. Thus the areas between the circuits and the resistor areas are now bare dielectric.

Step (c) involved activating the surfaces to be plated. Activation of the surfaces can range in complexity from a single dip in a precious metal activator (or non-precious metal or other activators know in the art) to a full plating cycle involving numerous steps. Typically the activation process will begin with a conditioner (surfactant or other type), followed by an activator (PdCl₂/SnCl₂ Colloid) and an accelerator. Clean water rinses are interposed between each chemical treatment. Regardless of the activation cycle chosen, its primary purpose is to treat the surfaces such that they initiate and accept plating. A wide variety of methods for achieving this are known in the art, any of which may be advantageously utilized here. Please refer to U.S. Patent Nos. 5,032,427 (Kukanskis, et al.), 4,976,990 (Bach et al.) and 4,863,758 (Rhodenizer), the teachings of which are incorporated herein by reference in their entirety.

In step (d) a plating mask is applied such that the resistor areas are defined in a negative manner. Generally, to accomplish this, the plating mask covers all or substantially all of the surfaces except for the resistor areas. The inventors have found that the plated resistors are more reliable if the plating mask allows for some plating overlap where the resistive plating meets the conductive circuit as opposed to covering all of the circuit with plating mask and causing the resistive plating to merely abut the conductive circuit. In any case, the plating mask can be any typical plating mask known in the art as long as it maintains its integrity in the subsequent plating bath. The plating mask may be screened onto the surface in the desired pattern or blanket coated, photoimaged and developed.

Step (e) involves plating the resistors. At this stage the plating will occur only on the areas not covered by the plating mask (ie. the resistor areas, preferably with some overlap onto the circuits where the resistor connects to the circuits). A variety of plating baths can be advantageously utilized. The inventors have found electroless nickel-phosphorous, electroless precious metal plating baths, including palladium-phosphorous, electroless plating baths, to be particularly useful in this regard. It may be optionally desirable to clean and/or accelerate the surfaces prior to plating.

Obviously, the thickness of the metal plated has a direct impact on the resistivity of the resultant resistor. The inventors have found that typically it is advantageous to plate metal thickness in the range of from 0.05 to 2.5 microns, and more preferable from 0.10 to 0.50 microns, depending upon the ultimate resistance desired.

Depending upon the ultimate resistance desired, the following factors may be adjusted to vary the resistivity of the resultant resistor: type of metal plated, thickness of the metal plated, length of the resistor and, width of the resistor. All of the foregoing factors may be varied to achieve the ultimate resistance desired.

Step (f) involves stripping away the plating mask. A stripping solution must be chosen to match the plating mask used. Typical plating masks can be stripped away in alkaline solution, however some require organic solvents.

The following examples are presented for illustrative purposes only and should not be taken as limiting in any way:

### Example I

Copper clad glass reinforced epoxy laminates were processed through the following sequence:
1. A dry film resist (Aquamer CF-1.5 available from MacDermid Imaging Technology, Inc.) was laminated to both copper surfaces of the laminate. The resist was then selectively exposed to ultraviolet light by exposure through a negative. The negative was designed such that the ultraviolet light impinged upon the circuit areas only, (ie. circuits defined in a positive manner and the areas between circuits and resistor areas are defined in a negative manner) The unexposed portions of the resist were developed away using a 1% by weight potassium carbonate solution at 90°F for 30 seconds.
2. The exposed copper surfaces were etched away by spraying ammoniacal copper chloride etchant at 110°F onto the surfaces until the exposed copper was cleanly etched away. The resist was then stripped away in a 10% by weight caustic solution.
3. The surfaces were activated to accept plating thereon by the following process sequence:
   a). MacDermid M-Conditioner, 110°F, 2 minutes
   b). MacDermid M-Preactivator, 75°F, 2 minutes
   c). MacDermid M-Activator, 100 °F, 5 minutes
   Clean water rinses were interspersed between each of the foregoing steps.
4. MacDermid Viatek PM #4 plating mask was then screened onto the surfaces such that it covered all of the surfaces except for the areas where the resistors were to be plated (the "resistor areas") (ie. such that the resistor areas were defined in a negative manner). The plating mask was then baked to cure for 5 minutes at 250°F. The width and length of the resistor areas, resistivity of electroless palladium-phosphorous, and the thickness of the palladium-phosphorous plate were used to design and predict the ultimate resistance of the plated resistors.
5. The resistor areas were then plated by immersion in MacDermid Pallas 52 electroless palladium-phosphorous plating bath, which was prepared per the supplied data sheet, at 150°F for 5 minutes. Approximately 0.1 to 0.2 microns of electroless palladium-phosphorous were plated.
6. The plating mask was then stripped away using a 10% by weight caustic solution at 150°F for 2 minutes and then thoroughly rinsed.

The boards were then electrically tested to determine the actual resistance of the plated resistors and the actual resistance was compared to the design resistance. Variances of 25-30% were recorded.

## Claims

1. A method of forming a resistor between two conductive areas, which areas are upon and separated by an insulative substrate, which method comprises plating a resistive material onto the insulative substrate, which is between the conductive areas, such that the resistive material connects the conductive areas.

2. A method according to claim 1 wherein the resistive material comprises a material selected from the group consisting of electroless nickel-phosphorous, electroless palladium-phosphorous, and electroless reuthenium-phosphorous.

3. A method according to claim 1 wherein the conductive areas are circuits on a printed circuit board.

4. A method according to claim 1 wherein the resistive matenal is plated to a thickness of from 0.05 to 2.5 microns.

5. A method according to claim 2 wherein the resistive material is plated to a thickness of from 0.05 to 2.5 microns.

6. A method according to claim 2 wherein the conductive areas are circuits on a printed circuit board.

7. A method according to claim 6 wherein the resistive material is plated to a thickness of from 0.05 to 2.5 microns.

8. A process for manufacturing a printed circuit board with integral plated resistors which process comprises:
a). applying an etch resist onto the surfaces of a metal clad laminate such that the resist defines the desired circuitry in a positive manner and the areas between the circuits including the locations for the resistors in a negative manner;
b). etching away exposed copper surfaces thereby yielding metal circuits separated by non-conductive surfaces;
c). stripping the resist;
d). activating the surfaces to accept plating thereon;
e). applying a plating mask such that the plating mask covers all or substantially all of the surfaces except for the locations for the resistors;
f). plating areas not covered by the plating resist mask resistive material; and
g). stripping away the plating mask.

9. A process according to claim 9 wherein the resistive material is plated to a thickness from 0.05 to 2.5 microns.

10. A process according to claim 8 wherein the resistive material is selected from the group consisting of electroless nickel-phosphorous, electroless palladium phosphorous, and electroless reuthenium-phosphorous.

11. A process according to claim 10 wherein the resistive material is plated to a thickness of from 0.05 to 2.5 microns.

12. A printed circuit board comprising conductive circuits upon and separated by an insulating substrate wherein the conductive circuits are connected at specific points by plated resistive material.

13. A printed circuit according to claim 12 wherein the resistive material is plated to a thickness of from 0.05 to 2.5 microns.

14. A printed circuit according to claim 12 wherein the resistive material is selected from the group consisting of electroless nickel-phosphorous and electroless palladium-phosphorous.
